Europäisches Patentamt

European Patent Office

Office européen des brevets

(11) Publication number: **0 192 646**
**B1**

# EUROPEAN PATENT SPECIFICATION

(45) Date of publication of patent specification: **29.11.89**

(51) Int. Cl.[4]: **H 01 L 23/48**

(21) Application number: **85903616.2**

(22) Date of filing: **03.07.85**

(86) International application number:
**PCT/US85/01292**

(87) International publication number:
**WO 86/01640 13.03.86 Gazette 86/06**

## (54) DIFFUSION BARRIER LAYER FOR INTEGRATED-CIRCUIT DEVICES.

(30) Priority: **27.08.84 US 644459**

(43) Date of publication of application:
**03.09.86 Bulletin 86/36**

(45) Publication of the grant of the patent:
**29.11.89 Bulletin 89/48**

(84) Designated Contracting States:
**BE DE FR GB IT NL SE**

(56) References cited:
**US-A-3 906 540**

**IBM Technical Disclosure Bulletin, volume 25, nr. 12, May 1983, NEW YORK, (US) C.Y. Ting: News structure for contact metallurgy , pages 6398-6399**

**Journal of Applied Physics, volume 54, nr.6, June 1983, New york, (US) M.Eizenberg et al.: "Interaction of reactively sputtered titanium carbide thin films with Si,SiO2, TiSi2 and Al ", pages 3195-3199,**

**IBM Technical Disclosure Bulletin, volume 25, nr. 12, May 1983, New York, (US) C.Y. Ting: News structure for contact metallurgy, pages 6398-6399**

(73) Proprietor: **AMERICAN TELEPHONE AND TELEGRAPH COMPANY**
**550 Madison Avenue**
**New York, NY 10022 (US)**

(72) Inventor: **DEAN, Robert, Earl**
**47 Valley View Road**
**High Bridge, NJ 08829 (US)**
Inventor: **STAROV, Vladimir**
**32 Brook Street**
**Berkeley Heights, NJ 07922 (US)**

(74) Representative: **Watts, Christopher Malcolm Kelway et al**
**AT&T (UK) LTD. AT&T Intellectual Property Division 5 Mornington Road**
**Woodford Green Essex IG8 OTU (GB)**

(56) References cited:
**Journal of Applied Physics, volume 54, nr.6, June 1983, New York (US), M.Eizenberg et al.:"Interaction of reactively sputtered titanium carbide thin films with Si,SiO2, TiSi2 and Al", pages 3195-3199,**

## Description

### Background of the invention

This invention relates to integrated-circuit devices and, more particularly, to metallization structures used in devices of the metal-oxide-semiconductor (MOS) type.

In some metallization structures for MOS devices, it is known to utilize a diffusion barrier to prevent certain deleterious effects in the devices. Thus, for example, it is known to interpose a diffusion barrier between silicon (or a silicide) and an overlying aluminum layer to prevent silicon-aluminum or silicide-aluminum interactions. In that way, the likelihood is minimized that the metallization will cause harmful effects such as penetration and shorting of shallow junctions included in the devices.

Heretofore, as described in *Journal of Applied Physics,* Vol. 54, No. 6, June 1983, pp. 3195—3199, and *Applied Physics Letters,* Vol. 36, No. 6, March 15, 1980, pp. 456—458, materials such as titanium nitride or titanium carbide have been proposed for forming the aforementioned diffusion barrier layers in MOS devices. In practice, however, these materials have often been observed to exhibit characteristics such as cracking, peeling and poor step coverage which dictate against their inclusion in high-quality devices. Thus, a need exists for improved barrier layers.

### Summary of the invention

In the invention as claimed a diffusion barrier consists mainly of titanium carbon and nitrogen. These elements are preferably present in the form of titanium carbonitride, which may be partially oxidised. By way of example, the layer is formed in a chemical-vapor-deposition (CVD) process. Titanium carbonitride layers formed in this way exhibit excellent barrier properties and, moreover, are characterized by low stress, conformal step coverage and relatively low resisitivity.

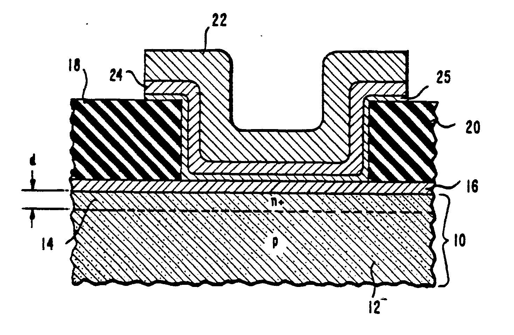

### Brief description of the drawing

The single-figure drawing, shows, in cross-section a portion of an illustrative MOS integrated-circuit device embodying the present invention.

### Detailed description

The portion of a semiconductor device shown in the drawing comprises a silicon body 10 including a p-type silicon region 12 having a standard $n^+$-type source or drain region 14 formed therein. In some devices, the depth $d$ of the p—$n^+$ junction is only about 100 to 300 nm (1000-to-3000 Ångström units) below the surface of the body 10.

By way of example, a layer 16 of a standard refractory metal silicide is included on the body 10 overlying the source or drain region 14. Illustratively, the layer 16 is approximately 80 to 100 nm (800-to-1000 Å) thick and comprises cobalt silicide, tantalum silicide, titanium silicide, platinum silicide, palladium silicide, molybdenum silicide, or tungsten silicide. The use of such a silicide on silicon to achieve high-conductivity contacts and interconnects in MOS devices is well known.

Also shown is a conventional patterned dielectric layer of phosphorus-doped silicon dioxide comprising regions 18 and 20 each about 1μm (10,000 Å) thick. High-conductivity contacts and interconnects are intended to be made through openings formed in the dielectric layer. In that way, electrical connections can be made to the source or drain region 14 and to other portions (not shown) of the device.

An electrical connection is made to the source or drain region 14 by a metallization structure that includes a patterned layer 22 that comprises a standard conductive material such as aluminum about 0.7-to-1 μm thick. Interposed between the aluminum layer 22 and the silicide layer 16 is a diffusion barrier layer 24 made in accordance with the present invention.

Advantageously, the barrier layer 24 comprises titanium carbonitride that is formed, for example, in a chemical-vapor-deposition (CVD) step as described below. Illustratively, the layer 24 is apprroximately 100 nm (1000 Å) thick. Such a layer constitutes an effective barrier that prevents or substantially reduces silicon-aluminum and silicide-aluminum interactions in the depicted MOS device.

The titanium carbonitride layer 24 comprises a thermally stable, low-resistance material that is not harmfully affected by the relatively high temperatures and other processing conditions typically encountered in a conventional MOS device fabrication sequence. Moreover, the material exhibits good step coverage over underlying layers and is etchable by the same standard processes commonly employed to pattern aluminum.

The invention is useful in a variety of other structural arrangements.

Thus, for example, the layer 24 is also useful as a barrier in a structure in which the silicide layer 16 is replaced with a layer of tungsten. Additionally, the layer 24 is useful as a barrier in a structure in which the titanium carbonitride layer 24 is deposited directly on the surface of the silicon body 10 to form a barrier between the body 10 and the aluminum layer 22.

A diffusion barrier to aluminum may also be desirable where the underlying semiconductor material to be contacted comprises a relatively thick doped polysilicon layer. The herein-described titanium carbnitride material constitutes an advantageous material for such a purpose. Further, in a composite gate metallization structure comprising a silicide overlying doped polysilicon, a titanium carbonitride layer interposed between the silicide and the polysilicon is useful to prevent undesired diffusion of dopants from the polysilicon into the silicide layer.

In some cases, it is advantageous to interpose a conductive adhesion promoter between the barrier layer 24 and the region underlying the layer 24. By way of example, such an adhesion promoter layer 25 is shown in the drawing between the barrier layer 24 and the underlying layer 16. Illustratively, 10 nm (100-Å)-thick layer of deposited titanium serves as an effective such adhesion promoter.

Illustratively, the starting material from which to form a titanium carbonitride layer comprises a known commercially available liquid designated Ti[N(CH₃)₂]₄. This liquid material, which is available in sealed ampoule form from, for example, Alpha Products, Morton Thiokol, Inc., Danvers, Massachusetts, exhibits a relatively low vapor pressure under ambient conditions.

Preferably, the titanium carbonitride layer is formed in a CVD process. A low-resistance diffusion barrier layer thus formed on an integrated-circuit device is characterized by low stress and conformal step coverage.

The first step in a preferred CVD process is to load at least 25 grams of the aforespecified starting material into a container. By way of example, the surface area of the loaded material in the container should be at least about 50 square centimeters. Loading should be done in a controlled inert atmosphere (for example in a nitrogen or argon atmosphere) at room temperature with particular emphasis on avoiding any oxygen or moisture contamination of the starting material.

The loaded container is then connected via a conventional high-conductance valve to the entrance side of a standard three-zone CVD reactor that contains integrated-circuit chips on which a titanium carbonitride layer is to be deposited. Illustratively, the temperature in the reactor ranges from about 325 degress Celsius at its entrance side to approximately 375 degrees Celsius at the exit or pump-down side thereof. The pressure in the reactor is established in the range of 5 to 13 Pa (40-to-100 milliTorr). A typical pumping speed is 4 cubic metres (150 cubic feet) per minute. Under these conditions, a titanium carbonitride layer forms on the chips in the reactor at a deposition rate of about 7 to 8 nm (70-to-80 Å) per minute. Effective barrier layers in the range of, for example 100 to 200 nm (1000-to-2000 Å) are thus formed on the chips in a relatively short processing time.

A CVD-deposited layer of the type specified above may be designated TiCₓNᵧ. Analysis of such layers indicates that in many cases x and y are each equal to or approximately equal to 1. More generally, in such layers $0.8<x<1.2$ and $0.8<y<1.2$.

Significantly, titanium carbonitride layers are patternable in the same step in which an overlying layer of aluminum is etched. Thus, for example, a standard boron trichloride and chlorine plasma utilized to carry out conventional anisotropic reactive ion (or sputter) etching of aluminum is also effective to anisotropically etch the underlying titanium carbonitride layer.

Although the primary emphasis herein is on forming oxygen-free layers of titanium carbonitride, in some cases the unavoidable inclusion of some oxygen therein is tolerable and may even be desirable. Layers of oxygen-containing titanium carbonitride generally exhibit a higher resistance than titanium carbonitride but do have effective diffusion barrier properties. Layers containing up to 25 atomic percent oxygen exhibit acceptable resistivity for many device applications and therefore can be used.

## Claims

1. An integrated-circuit device including a metallization structure comprising:
a first region (22) of electrically conductive material,
a second region (16), and
a diffusion barrier layer (24) interposed between the first and second regions,
characterized in that the diffusion barrier consists mainly of titanium, carbon and nitrogen.

2. A device as claimed in claim 1 wherein said barrier layer consists mainly of titanium carbonitride.

3. A device as claimed in claim 2 wherein said titanium, carbon and nitrogen is in the form TiCₓNᵧ where $0.8<x<1.2$ and $0.8<y<1.2$.

4. A device as claimed in claim 2 or claim 2 wherein said barrier layer is 100-to-200 nm thick.

5. A device as claimed in any of the preceding claims wherein said second region comprises a layer (25) of conductive adhesion promoter directly underlying and in contact with said barrier layer.

6. A device as claimed in claim 5 wherein said adhesion promoter layer is of titanium.

7. A device as claimed in any of the preceding claims wherein said first region comprises a layer of aluminum overlying said barrier layer.

8. A device as claimed in any of the preceding claims wherein said second region comprises a layer of silicide.

9. A device as claimed in claim 8 wherein said silicide is cobalt silicide, tantalum silicide, titanium silicide, platinum silicide, palladium silicide, molybdenum silicide or tungsten silicide.

10. A device as claimed in any of claims 1 to 7 wherein said second region comprises a layer of tungsten.

11. A device as claimed in any of the preceding claims wherein said second region comprises a silicon body (10) having a p—n⁺ junction formed below the surface thereof.

12. A method of making an integrated circuit as claimed in any of the preceding claims wherein the said diffusion barrier layer between the first region (22) and the second region (16) is formed by chemical vapour deposition.

13. A method as claimed in claim 12 comprising the additional step of correspondingly patterning the first region and the diffusion barrier layer.

14. A method as claimed in claim 13 wherein the first region is an aluminum layer and the diffusion barrier layer consists mainly of titanium carbonitride comprising sequentially etching the first region and the diffusion barrier by the same etchant.

15. A method as claimed in claim 14 wherein said etchant comprises a plasma derived from boron trichloride and chlorine.

## Patentansprüche

1. Integriertes Schaltungsbauteil mit einer Metallisierungsanordnung und mit

einer ersten Zone (22) aus elektrisch leitendem Material, einer zweiten Zone (16) und

einer Diffusionssperrschicht (24) zwischen der ersten und zweiten Zone,

dadurch gekennzeichnet, daß die Diffusionssperrschicht in der Hauptsachse aus Titan, Kohlenstoff und Stickstoff besteht.

2. Bauteil nach Anspruch 1, bei dem die Sperrschicht in der Hauptsache aus Titancarbonitrid besteht.

3. Bauteil nach Anspruch 2, bei dem Titan, Kohlenstoff und Stickstoff in der Form $TiC_xN_y$ vorliegen, wobei $0,8<x<1,2$ und $0,8<y<1,2$ sind.

4. Bauteil nach Anspruch 2 oder 3, bei dem die Sperrschicht 100 bis 200 nm dick ist.

5. Bauteil nach einem der vorhergehenden Ansprüche, bei dem die zweite Zone eine Schicht (25) aus leitendem Adhäsionsverbesserer direkt unterhalb und in Kontakt mit der Sperrschicht umfaßt.

6. Bauteil nach Anspruch 5, bei dem die Adhäsionsverbesserungsschicht aus Titan besteht.

7. Bauteil nach einem der vorhergehenden Ansprüche, bei dem die erste Zone eine Schicht aus Aluminium über der Sperrschicht aufweist.

8. Bauteil nach einem der vorhergehenden Ansprüche, bei dem die zweite Zone eine Schicht aus Silicid umfaßt.

9. Bauteil nach Anspruch 8, bei dem das Silicid Kobaltsilicid, Tantalsilicid, Titansilicid, Platinsilicid, Palladiumsilicid, Molybdänsilicid oder Wolframsilicid ist.

10. Bauteil nach einem der Ansprüche 1 bis 7, bei dem die zweite Zone eine Schicht aus Wolfram umfaßt.

11. Bauteil nach einem der vorhergehenden Ansprüche, bei dem die zweite Zone einen Siliciumkörper (10) umfaßt, der einen unter seiner Oberfläche gebildeten $pn^+$-Übergang besitzt.

12. Verfahren zur Herstellung einer integrierten Schaltung nach einem der vorhergehenden Ansprüche, bei dem die Diffusionssperrschicht zwischen der ersten Zone (22) und der zweiten Zone (16) durch chemische Abscheidung aus der Dampfphase gebildet ist.

13. Verfahren nach Anspruch 12, bei dem zusätzlich die erste Zone und die Diffusionssperrschicht sich entsprechend hergestellt sind.

14. Verfahren nach Anspruch 13, bei dem die erste Zone eine Aluminiumschicht ist und die Diffusionssperrschicht hauptsächlich aus Titancarbonitrid besteht und bei dem die erste Zone und die Diffusionssperrschicht nacheinander mit dem gleichen Ätzmittel geätzt werden.

15. Verfahren nach Anspruch 14, bei dem das Ätzmittel ein aus Bortrichlorid und Chlor abgeleitetes Plasma umfaßt.

## Revendications

1. Un dispositif à circuit intégré comprenant une structure de métallisation qui comporte:

une première région (22) en un matériau conducteur de l'électricité,

une seconde région (16), et

une couche de barrière de diffusion (24) interposée entre les première et seconde régions,

caractérisé en ce que la couche de barrière de diffusion consiste essentiellement en titane, en carbone et en azote.

2. Un dispositif selon la revendication 1, dans lequel la couche de barrière consiste essentiellement en carbonitrure de titane.

3. Un dispositif selon la revendication 2, dans lequel le titane, le carbone et l'azote se présentent sous la forme $TiC_xN_y$, avec $0,8<x<1,2$ et $0,8<y<1,2$.

4. Un dispositif selon la revendication 2 ou la revendication 3, dans lequel la couche de barrière mesure de 100 à 200 nm d'épaisseur.

5. Un dispositif selon l'une quelconque des revendications précédentes, dans lequel la second région comprend une couche (25) d'un agent conducteur favorisant l'adhérence, qui se trouve directement au-dessous de la couche de barrière et qui est en contact avec cette dernière.

6. Un dispositif selon la revendication 5, dans lequel la couche d'agent favorisant l'adhérence est en titane.

7. Un dispositif selon l'une quelconque des revendications précédentes, dans lequel la première région comprend une couche d'aluminium recouvrant la couche de barrière.

8. Un dispositif selon l'une quelconque des revendications précédentes, dans lequel la second région comprend une couche de siliciure.

9. Un dispositif selon la revendication 8, dans lequel le siliciure est du siliciure de cobalt, du siliciure de tantale, du siliciure de titane, du siliciure de platine, du siliciure de palladium, du siliciure de molybdène ou du siliciure de tungstène.

10. Un dispositif selon l'une quelconque des revendications 1 à 7, dans lequel la seconde région consiste en une couche de tungstène.

11. Un dispositif selon l'une quelconque des revendications précédentes, dans lequel la seconde région consiste en un bloc de silicium (10) qui comporte une jonction $p{-}n^+$ formée au-dessous de sa surface.

12. Un procédé de fabrication d'un circuit intégré selon l'une quelconque des revendications précédentes, dans lequel la couche de barrière de diffusion entre la première région (22) et la seconde région (16), est formée par dépôt chimique en phase vapeur.

13. Un procédé selon la revendication 12, comprenant l'étape supplémentaire qui consiste à définir un motif de façon correspondante dans la première région et dans la couche de barrière de diffusion.

14. Un procédé selon la revendication 13, dans lequel la première région est une couche d'aluminium et la couche de barrière de diffusion consiste essentiellement en carbonitrure de titane, comprenant la gravure séquentielle de la première région et de la barrière de diffusion avec le même agent d'attaque.

15. Un procédé selon la revendication 14, dans lequel l'agent d'attaque consiste en un plasma obtenu à partir de chlore et de trichlorure de bore.